Europäisches Patentamt

European Patent Office

Office européen des brevets

(19)

(11) Numéro de publication : **0 334 705 B1**

(12) **FASCICULE DE BREVET EUROPEEN**

(45) Date de publication du fascicule du brevet :
03.06.92 Bulletin 92/23

(51) Int. Cl.[5] : **H03H 9/13,** H03H 9/17,
H03B 5/30

(21) Numéro de dépôt : **89400654.3**

(22) Date de dépôt : **08.03.89**

(54) **Résonateurs en matériau solide élastique et oscillateurs à haute stabilité.**

(30) Priorité : **24.03.88 FR 8803864**

(43) Date de publication de la demande :
**27.09.89 Bulletin 89/39**

(45) Mention de la délivrance du brevet :
**03.06.92 Bulletin 92/23**

(84) Etats contractants désignés :
**DE GB**

(56) Documents cités :
**GB-A- 1 173 374
US-A- 1 921 501
US-A- 2 002 191
US-A- 2 101 272
US-A- 2 133 647
THE JOURNAL OF THE ACOUSTICAL
SOCIETY OF AMERICA, vol. 39, no. 2, février
1966, pages 346-361; P. LLOYD et
al.:"Finite-difference method for the investigation of the vibrations of solids and the evaluation of the equivalent-circuitcharacteristics
of piezoelectric resonators. I,II"**

(56) Documents cités :
**PATENT ABSTRACTS OF JAPAN, vol. 4, no.
148 (E-30)[630], 18 octobre 1980, page 146 E
30; & JP-A-55 100 722 (MURATASEISAKUSHO
K.K.) 31-07-1980
WIRELESS WORLD, vol. 72, no. 1, janvier 1966,
page 31; "Resonant-gate transistor"**

(73) Titulaire : **OFFICE NATIONAL D'ETUDES ET
DE RECHERCHES
AEROSPATIALES(O.N.E.R.A.)
Etablissement Public de l'Etat 29 avenue de la
Divison Leclerc
F-92320 Châtillon (FR)**

(72) Inventeur : **Beaussier, Jacques
11, Rue Louis Boussard
F-91320 Wissous (FR)**
Inventeur : **Breuzet, Michel
100, Boulevard de la République
F-92250 La Garenne colombes (FR)**
Inventeur : **Gay, Michel
7, Rue Flemming
F-94260 Fresnes (FR)**
Inventeur : **Uebersfeld, Jean
27 Rue Gazan
F-75014 Paris (FR)**

(74) Mandataire : **Cabinet Martinet & Lapoux
BP 405
F-78055 Saint Quentin en Yvelines Cédex (FR)**

## Description

La présente invention concerne, de manière générale, des résonateurs et des oscillateurs pour leur mise en oeuvre. Plus précisément l'invention concerne des résonateurs et des oscillateurs à haute stabilité dans la gamme des basses et moyennes fréquences.

Les oscillateurs de haute stabilité actuellement les plus performants utilisent pour la plupart des résonateurs en matériau piézoélectrique, principalement le quartz. D'autres matériaux piézoélectriques sont également employés tels que la berlinite. Dans ce type de résonateur en matériau piézoélectrique, l'effet piézoélectrique est un moyen aisé de convertir en énergie mécanique l'énergie d'un champ électrique appliqué au matériau piézoélectrique. La variation relative de fréquence pour les oscillateurs à résonateur à quartz de haute stabilité est au mieux de l'ordre de $10^{-10}$. Dans le cas des oscillateurs à résonateur à quartz "bas de gamme" largement employés dans les appareillages électroniques, la variation relative de fréquence se situe entre $10^{-5}$ et $10^{-7}$. Cette variation relative de fréquence est pour une part importante due aux dérives du résonateur dans le temps et un fonction de conditions de l'environnement telles que la température.

Les dérives d'un résonateur à quartz sont, en partie, inhérentes au matériau utilisé, le quartz. Des essais ont mis en évidence les limitations du quartz qui constitue le meilleur matériau piézoélectrique connu. Le quartz et plus généralement tout matériau cristallin comprend des défauts de structure et des impuretés dans les canaux intersticiels. La mobilité relative de ces impuretés dans les canaux intersticiels provoque des dérives temporelles de fréquence et des sensibilités excessives aux rayonnements ionisants notamment lorsque le quartz est excité en mode de flexion. Les résonateurs à quartz de haute stabilité nécessitent l'emploi de quartz de très bonne qualité. Actuellement, il devient difficile de se procurer du quartz naturel de qualité suffisante. De plus, la synthèse du quartz artificiel n'est pas totalement maîtrisée.

Par ailleurs, la sensibilité du quartz aux variations de température impose l'emploi, pour ces oscillateurs à haute stabilité, d'enceintes thermostatées coûteuses.

La présente invention vise principalement à fournir des résonateurs à haute stabilité réalisables avec un matériau solide élastique quelconque, afin d'échapper aux limitations inhérentes aux structures cristallines et de résoudre les inconvénients de la technique antérieure. Une très large gamme de matériaux solides élastiques est utilisable.

A cette fin, un résonateur selon l'invention est tel que défini par la revendication 1.

Un autre objectif de l'invention est de fournir des oscillateurs à haute stabilité pour la mise en oeuvre des résonateurs selon l'invention.

A cette fin, un oscillateur selon l'invention est tel que défini par la revendication 10.

L'oscillateur peut comprendre également des moyens pour polariser des électrodes du résonateur à des tensions continues, des moyens reliés en entrée aux secondes électrodes du résonateur pour produire un signal représentatif d'une variation de capacité entre lesdites électrodes et une masse de référence, ladite variation de capacité étant due à des vibrations de la plaque résonnante du résonateur, et des moyens, en cascade avec lesdits moyens pour produire un signal représentatif d'une variation de capacité, pour diviser en fréquence par 2 ledit signal.

Les résonateurs selon l'invention autorisent la réalisation d'oscillateurs à haute stabilité dans la gamme de fréquences de 50 à 500 kHz. Un circuit multiplieur peut être associé à l'oscillateur lorsque la fréquence souhaitée est supérieure à 500 kHz. Pour de nombreuses applications le signal produit par un oscillateur selon l'invention est utilisable directement, sans traitement par des circuits de division de fréquence comme cela est souvent nécessaire dans le cas des oscillateurs à quartz fonctionnant dans la gamme de 5 à 10 MHz.

Une réalisation particulière d'un résonateur selon l'invention à partir de silice vitreuse, matériau amorphe isolant, a permis d'atteindre un coefficient de qualité de l'ordre de $10^7$ à la fréquence de résonance de 50 kHz.

De plus, l'utilisation de silicium pour la réalisation du résonateur permet aisément l'intégration complète d'un oscillateur sous forme très réduite dans un circuit intégré monolithique ou hybride.

D'autres avantages et caractéristiques de l'invention apparaîtront plus clairement à la lecture de la description suivante de plusieurs réalisations préférées de l'invention en référence aux figures annexées correspondantes dans lesquelles :

– La Fig. 1 est une représentation schématique d'un résonateur de principe selon l'invention ;

– Les Figs. 2 et 3 montrent respectivement une vue en perspective et une vue en coupe d'une première réalisation préférée d'un résonateur comprenant une plaque résonnante carrée et deux électrodes ;

– Les Figs. 4 et 5 montrent respectivement une vue en perspective et une vue en coupe d'une seconde réalisation préférée d'un résonateur comprenant une plaque résonnante rectangulaire et quatre électrodes ;

– La Fig. 6 représente une première réalisation préférée d'un oscillateur selon l'invention dans lequel des électrodes d'action et de détection du résonateur sont polarisées à des tensions continues ; et

– La Fig. 7 représente une seconde réalisation préférée d'un oscillateur dans lequel une électrode d'action du résonateur n'est pas polarisée à une tension continue et un diviseur de fréquence par 2 est inclus dans la boucle de l'oscillateur afin de pallier à une multiplication de fréquence par 2 introduite par le résonateur.

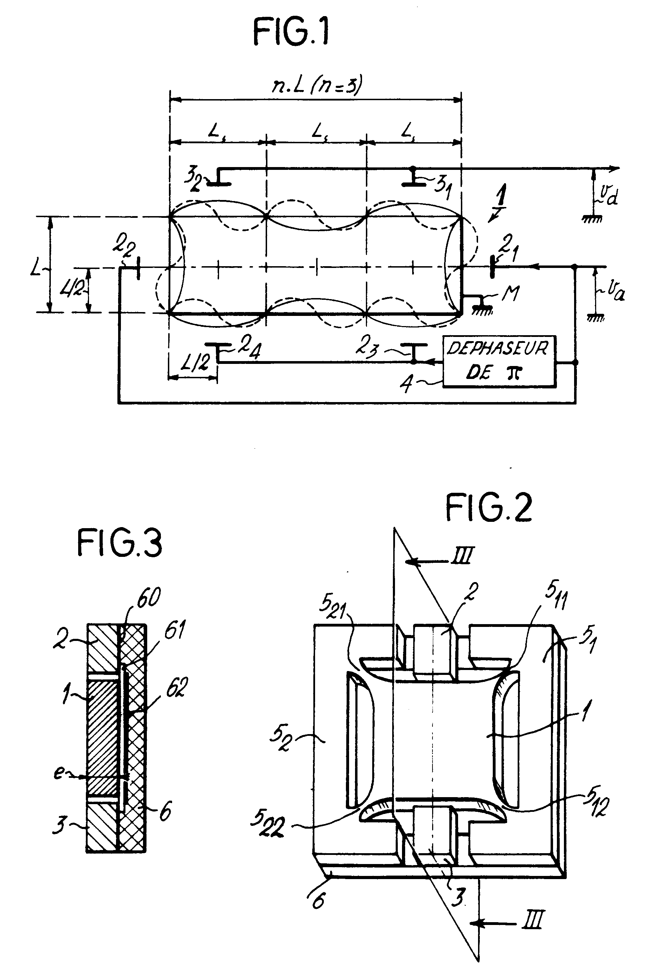

En référence à la Fig. 1, un résonateur de principe selon l'invention comprend une plaque parallélépipédique 1 d'épaisseur e, de largeur L et de longueur n.L, où n est un entier supérieur ou égal à 1, ici égal à 3, une ou plusieurs électrodes d'action $2_1$ à $2_4$ et une ou plusieurs électrodes de détection $3_1$ et $3_2$.

La plaque 1 est en matériau solide élastique. Différents types de matériaux sont utilisables, conducteurs, semi-conducteurs ou isolants, amorphes ou cristallisés, piézoélectriques ou non. Une telle plaque à structure parallélépipédique excitée par des ondes acoustiques de volume en mode de contour présente des résonances pour différentes fréquences de vibration. Pour exciter un mode de contour dans la plaque 1, les électrodes d'action $2_1$ à $2_4$ sont placées à la périphérie de la plaque 1 face à des chants d'épaisseur e de la plaque 1, et un signal d'action $v_a$ destiné à exciter la plaque est appliqué aux électrodes $2_1$ à $2_4$. Pour une plaque 1 en matériau isotrope, l'épaisseur e est quelconque car elle n'intervient pas sur le mode de vibration. Pour une plaque 1 présentant une anisotropie dans le sens de l'épaisseur e, l'épaisseur e doit être faible afin de réduire les effets de l'anisotropie. Des essais réalisés avec différents types de matériaux ont montré que le mode de Lamé selon lequel les ondes se propagent dans des directions à 45° des bords de la plaque 1 est un mode d'excitation intéressant de part les coefficients de qualité élevés qui sont obtenus. Les résonateurs selon l'invention décrits par la suite fonctionnent en mode de Lamé. D'autres modes de contour sont utilisables tout en restant dans le cadre de l'invention.

Des déformations de la plaque 1 excitée en mode de Lamé à une fréquence fondamentale de résonance $F_0$ sont montrées en traits fins continus à la Fig. 1. En traits fins discontinus sont montrées des déformations de la plaque 1 excitée à une première fréquence de résonance harmonique $2F_0$. Les électrodes d'action et de détection $2_1$ à $2_4$ et $3_1$ et $3_2$ sont positionnées à la périphérie de la plaque 1 en regard de ventres de vibration. Afin de ne pas perturber les vibrations de la plaque 1, les électrodes $2_1$ à $2_4$, $3_1$ et $3_2$ n'adhèrent pas à la surface des chants de la plaque 1 ; elles sont placées à faible distance de la plaque 1, typiquement à une distance de l'ordre de 100 μm.

Les électrodes d'action et de détection $2_1$ à $2_4$, $3_1$ et $3_2$ montrées à la Fig. 1 sont positionnées pour une résonance de la plaque 1 à la fréquence fondamentale $F_0$. Ce positionnement est donné à titre d'exemple, d'autres positionnements étant possibles. Les électrodes $2_1$ et $2_2$ sont positionnées symétriquement à mi-largeur L/2, selon un axe longitudinal de la plaque 1, respectivement en regard de premier et second chants en bout de la plaque 1. Les électrodes $2_3$ et $2_4$ sont positionnées en regard d'un premier chant longitudinal de la plaque 1 ; elles sont séparées entre elles d'une distance égale à 2L et sont respectivement à des distances égales à L/2 des premier et second chants en bout de plaque. Les électrodes $2_1$ et $2_2$ sont positionnées face à des ventres de vibration déphasés de $\pi$ par rapport aux ventres de vibration en face desquels sont positionnées les électrodes $2_3$ et $2_4$. Afin de compenser ce déphasage, il est prévu un déphaseur de $\pi$, 4. Les électrodes $2_1$ et $2_2$ reçoivent directement le signal d'action $v_a$. Les électrodes $2_3$ et $2_4$ reçoivent le signal d'action $v_a$ à travers le déphaseur 4.

Les électrodes de détection $3_1$ et $3_2$ sont positionnées en regard d'un second chant longitudinal de la plaque 1 parallèle au premier chant longitudinal, symétriquement par rapport aux électrodes d'action $2_3$ et $2_4$ et respectivement à des distances égales à L/2 des premier et second chants en bout de plaque. Les électrodes $3_1$ et $3_2$ délivrent un signal $v_d$ représentatif des vibrations de la plaque 1.

La plaque 1 de surface 3LxL présente 11 noeuds de vibration lorsqu'elle résonne à la fréquence fondamentale $F_0$, 3 noeuds localisés respectivement aux centres de 3 carrés LxL inscrits dans la plaque 1, 4 noeuds localisés respectivement aux 4 coins de la plaque 1, 2 noeuds localisés sur le premier chant longitudinal de la plaque 1 respectivement à des distances égales à L des premier et second chants en bout de plaque, et 2 noeuds localisés sur le second chant longitudinal respectivement à des distances égales à L des premier et second chants en bout de plaque. De préférence, afin de perturber au minimum la résonance de la plaque 1 et d'obtenir des coefficients de qualité élevés, la plaque 1 est fixée à un support en des points correspondant à des noeuds de vibration.

Selon le type de matériau constituant la plaque 1, différents effets physiques interviennent pour induire des vibrations dans la plaque 1 à partir des électrodes d'action $2_1$ à $2_4$ et pour détecter les vibrations de la plaque 1 à l'aide des électrodes de détection $3_1$ et $3_2$.

Ainsi dans le cas d'une plaque 1 en matériau conducteur, tel par exemple que le duralumin (Au4G), l'effet physique intervenant est l'effet capacitif. De même, l'effet capacitif est également utilisé dans le cas où la plaque 1 est en matériau semi-conducteur, un dopage en surface de la plaque 1 assurant sa conductivité. Le signal d'action $v_a$ est alors appliqué entre les électrodes d'action $2_1$ à $2_4$ et la plaque 1 reliée à une borne de masse M comme montré à la Fig. 1. De même, le signal détecté $v_d$ est fourni entre les électrodes de détection $3_1$ et $3_2$ et la borne de masse M.

Dans le cas où la plaque 1 est en matériau isolant non piézoélectrique, amorphe ou cristallisé, les effets capacitif et électrostrictif sont utilisables. Si les chants de la plaque 1 en regard des électrodes sont métallisés et reliés à la borne de masse M, l'effet agissant est essentiellement l'effet capacitif. Si les chants de la plaque 1 ne sont pas métallisés, une masse métallique de référence par exemple le support est reliée à la borne de masse M de manière à ce que les lignes du champ électrique produit par le signal d'action $v_a$ traversent le matériau isolant. Les effets capacitif et électrostrictif interviennent dans ce dernier cas.

De même dans le cas où la plaque 1 est en matériau isolant piézoélectrique, les chants de la plaque 1 en regard des électrodes peuvent être métallisés et reliés à la borne de masse M, ou peuvent être non métallisés et une masse métallique de référence telle que le support est alors reliée à la borne de masse M. Dans le premier cas, l'effet capacitif intervient. Dans le second cas, c'est l'effet piézoélectrique qui opère essentiellement.

Lorsque les effets capacitif et électrostrictif sont les effets agissant, la relation entre la tension v à une électrode d'action ou de détection et les forces dans la plaque 1 est donnée par l'égalité :

$f = \alpha.v^2$, où $\alpha$ est un coefficient de proportionnalité.

En supposant une tension sinusoïdale $v = V.\cos\omega t$, V et $\omega$ étant respectivement l'amplitude maximale et la pulsation de la tension v, les forces dans la plaque 1 s'expriment par :

$f = \alpha.V^2.(1+\cos 2\omega t)/2$.

Cette dernière égalité montre donc que la plaque 1 vibre à une fréquence $F=\omega/\pi$ qui est double par rapport à la fréquence $\omega/2\pi$ de la tension v.

Afin de linéariser la relation tension-force, une électrode est éventuellement polarisée à une tension continue U. Les forces dans la plaque 1 deviennent :

$f = \alpha.(U+V.\cos\omega t)^2 = \alpha.(U^2+2.U.V\cos\omega t+V^2.\cos^2\omega t)$.

La linéarisation de la relation tension-force est obtenue avec le terme $2.U.V.\cos\omega t$.

Dans le cas où l'effet piézoélectrique est prépondérant, cet effet étant linéaire, il n'est pas nécessaire de polariser les électrodes.

La fréquence fondamentale de résonance $F_0$ de la plaque 1 lorsque celle-ci est constituée d'un matériau isotrope s'exprime :

$F_0 = v_t.(2)^{1/2}/(2.L)$, où $v_t$ est la vitesse des ondes de cisaillement dans la plaque 1.

Lorsque la plaque 1 est constituée d'un matériau cristallin anisotrope, il convient de choisir une orientation judicieuse des axes de la plaque 1 par rapport aux axes cristallographiques du matériau afin que le mode de Lamé dans une telle plaque garde une structure nodale analogue à la structure nodale obtenue dans un matériau isotrope.

Ainsi, par exemple lorsque la plaque 1 est en matériau cristallin du système cubique tel que le silicium ou le germanium, le plan de surface nLxL de la plaque 1 doit être normal à un premier axe cristallographique x du matériau et les bords de la plaque 1 doivent être parallèles ou à 45° par rapport à des second y et troisième z axes cristallographiques du matériau. Deux angles de coupe à 0° ou à 45° par rapport aux second et troisième axes y et z sont donc possibles ; ces deux angles de coupe à 0° et 45° déterminent deux fréquences fondamentales de résonance différente.

Dans le cas d'un angle de coupe à 0°, la fréquence fondamentale de résonance $F_0$ est donnée par la relation :

$F_0 = (C_{11}-C_{12})^{1/2}/(2.L.\rho)^{1/2}$.

Dans le cas d'un angle de coupe à 45°, cette même fréquence est donnée par la relation :

$F_0 = (C_{66})^{1/2}/(2.L.\rho)^{1/2}$.

Dans les relations ci-dessus, $\rho$ représente la masse volumique du matériau et $C_{11}$, $C_{12}$ et $C_{66}$ représentent les composantes $C_{ij}$ du tenseur de rigidité du matériau constituant la plaque 1, respectivement d'indices $(i, j)=(1, 1)$, $(i, j)=(1, 2)$ et $(i, j)=(6, 6)$.

Lorsque la plaque 1 est par exemple en quartz, matériau piézoélectrique, la plaque 1 doit être coupée de sorte que son plan de surface nLxL corresponde à un plan d'isotropie du quartz. Dans ces conditions, pour une plaque 1 de faible épaisseur, la fréquence fondamentale de résonance $F_0$ est donnée par la même relation que pour un matériau isotrope :

$F_0 = v_{tp}.(2)^{1/2}/(2.L)$,

où $v_{tp}$ est la vitesse des ondes de cisaillement dans la plaque de quartz, donnée par la relation :

$v_{tp} = ((C_{66}-(C_{14}^2/C_{44}))/\rho)^{1/2}$,

$\rho$ étant la masse volumique du quartz.

En référence aux Figs. 2 et 3, une première réalisation préférée du résonateur selon l'invention comprend une plaque carrée 1 de surface LxL, une électrode d'action 2 et une électrode de détection 3, deux pattes de fixation $5_1$ et $5_2$, et une plaque support 6.

La plaque 1 et les pattes de fixation $5_1$ et $5_2$ constituent une pièce monobloc taillée dans une plaque de silicium. Les pattes de fixation $5_1$ et $5_2$ ont une forme en U et entourent la plaque 1. Quatre languettes $5_{11}$, $5_{12}$ et $5_{21}$, $5_{22}$ relient quatre coins de la plaque 1 respectivement à deux coins internes de la patte de fixation $5_1$ et à deux coins internes de la patte de fixation $5_2$.

Le support 6 est en matériau isolant tel que céramique. Ledit support 6 est par exemple le support en céramique d'un circuit intégré hybride dans lequel est intégré le résonateur selon l'invention. Sur un bord périphérique 60 du support 6 surplombant légèrement, typiquement de 100 μm, une face supérieure centrale 61 du support 6 sont fixées par collage les pattes de fixation $5_1$ et $5_2$ de la plaque 1 et les électrodes 2 et 3. Les électrodes 2 et 3 sont alignées dans un plan de symétrie P du résonateur respectivement en regard de deux chants parallèles de la plaque 1. Les pattes de fixation $5_1$ et $5_2$ sont localisées symétriquement de part et d'autre du plan P. La face supérieure 61 du support 6 comprend une partie métallisée 62 destinée à être reliée à la masse de référence. Cette partie métallisée 62 est localisée en-dessous de la plaque 1 de manière à ce que la plaque 1 soit traversée par des lignes d'un champ électrique induit par le signal d'action $v_a$ appliqué à l'électrode d'action 2.

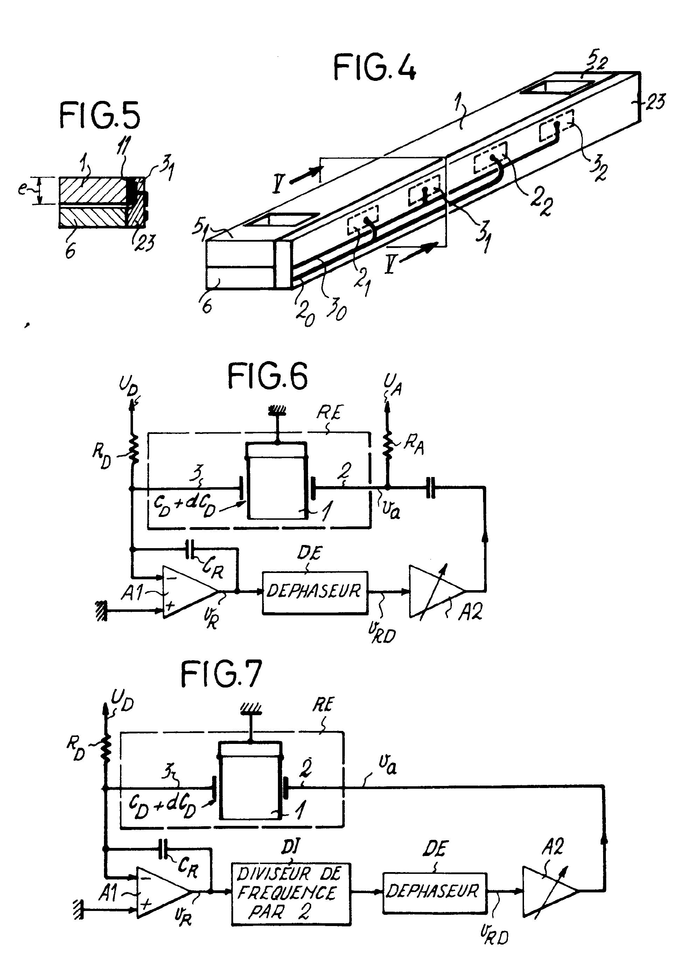

En référence aux Figs. 4 et 5, une seconde réalisation préférée du résonateur selon l'invention comprend une plaque rectangulaire 1 de surface nLxL, icin=4, une barrette d'électrodes 23, deux pattes de fixation $5_1$ et $5_2$, et une plaque support 6.

De même que dans la première réalisation préférée décrite précédemment, la plaque 1 et les pattes de fixation $5_1$ et $5_2$ constituent une pièce monobloc. Cette pièce monoblocest, pour cette réalisation, en silice vitreuse. Quatre languettes, aux quatre coins de la plaque rectangulaire 1, relient la plaque 1 aux pattes de fixation $5_1$ et $5_2$. Les pattes de fixation $5_1$ et $5_2$ sont fixées par collage respectivement à deux extrémités de la plaque support 6. Un chant longitudinal 11 de la plaque 1 en regard de la barrette d'électrodes 23 est métallisé pour être relié à la masse de référence.

La barrette d'électrodes 23 qui est par exemple une barrette rigide de circuit imprimé double face supporte deux électrodes d'action $2_1$ et $2_2$ et deux électrodes de détection $3_1$ et $3_2$. Les électrodes $2_1$, $2_2$, $3_1$ et $3_2$ sont situées sur une première face de la barrette 23 ; elles sont alignées face au chant métallisé 11 de la plaque 1 et en regard respectivement de quatre ventres de vibration de la plaque 1 lorsque celle-ci vibre à la fréquence fondamentale de résonance $F_0$. La barrette 23 est collée en des extrémités aux pattes de fixation $5_1$ et $5_2$ de la plaque 1 et en une partie inférieure à un chant longitudinal du support 6. Une seconde face de la barrette 23 comprend deux bandes conductrices imprimées $2_0$ et $3_0$ auxquelles sont reliées respectivement les électrodes d'action $2_1$ et $2_2$ et les électrodes de détection $3_1$ et $3_2$. Dans cette second réalisation, les signaux d'action $v_a$ et de détection $v_d$ sont déphasés de $\pi$.

En référence à la Fig. 6, un premier oscillateur à haute stabilité mettant en oeuvre un résonateur selon l'invention RE comprend outre le résonateur RE, deux résistances de polarisation $R_D$ et $R_A$, un premier amplificateur A1, un déphaseur DE, et un second amplificateur A2.

Le résonateur RE comprend une plaque carrée 1, une électrode d'action 2 et une électrode de détection 3. Les électrodes 2 et 3 sont disposées en regard respectivement de deux chants parallèles métallisés de la plaque 1 ; ces chants sont reliés à la masse de référence. L'électrode de détection 3 et le chant métallisé en regard forment un condensateur de capacité $C_D$ ayant une variation dynamique de capacité $dC_D$ lorsque la plaque 1 vibre.

La résistance de polarisation $R_A$ a une première borne reliée à l'électrode d'action 2 et à une sortie de l'amplificateur A2, et une second borne portée à une première tension continue de polarisation $U_A$. La résistance de polarisation $R_D$ a une première borne reliée à l'électrode de détection 3 et à une entrée inverse - de l'amplificateur A1, et une seconde borne portée à une seconde tension continue de polarisation $U_D$.

L'amplificateur A1 est du type amplificateur opérationnel ; il comprend une entrée directe + reliée à la masse de référence et un condensateur $C_R$ placé en contre-réaction entre une sortie et l'entrée - de l'amplificateur A1. Lorsque le résonateur RE résonne à la fréquence fondamentale $F_0$, l'amplificateur A1 fournit en sortie un signal $v_R$ qui est appliqué à une entrée du déphaseur DE. Le signal $v_R$ est donné par la relation :

$$v_R = U_D.(\Delta C/C_R).\cos(\omega_0.t+\Phi_1)$$
$$= k_1.V_a.\cos(\omega_0.t+\Phi_1),$$

où $\Delta C$ est l'amplitude maximale de la variation de capacité dC, $\omega_0$ la pulsation correspondante à la fréquence $F_0$, $\Phi_1$ un déphasage introduit par le résonateur RE et l'amplificateur A1 entre le signal d'action $v_a=V_a.\cos(\omega_0.t)$ et le signal $v_R$, et $k_1$ un coefficient de proportionnalité entre les amplitudes des signaux $v_a$ et $v_R$.

Le déphaseur DE a pour fonction d'introduire un déphasage $\Phi_{DE}$ dans le signal $V_R$ ; il délivre en sortie le signal :

$$v_{RD} = k_{DE}.k_1.V_a.\cos(\omega_0.t+\Phi_1+\Phi_{DE}),$$ où $k_{DE}$ est une atténuation apportée sur le signal par le déphaseur DE. Le signal $v_{RD}$ est appliqué à une entrée de l'amplificateur A2.

L'amplificateur A2 est un amplificateur à gain ajustable G et à faible impédance de sortie. L'amplificateur A2 est par exemple, comme l'amplificateur A1 de type amplificateur opérationnel. L'amplificateur A2 délivre en sortie le signal d'action $v_a$ fourni à l'électrode d'action 2. Compte tenu du gain G et d'un déphasage $\Phi_2$ introduit dans le signal $v_{RD}$ par l'amplificateur A2, il vient la relation :

$$v_a = V_a.\cos(\omega_0.t) = G.k_{DE}.k_1.V_a.\cos(\omega_0.t+\Phi_1+\Phi_{DE}+\Phi_2).$$

De cette relation sont déduites les conditions classiques de gain et de phase pour le maintien des oscillations de l'oscillateur :

$$G.k_{DE}.k_1 = 1 \text{ et}$$
$$\Phi_1+\Phi_{DE}+\Phi_2 = p.2.\pi,$$

où p est un entier.

Le gain G et/ou le coefficient $k_1$ sont ajustés pour satisfaire à la condition de gain $G.k_{DE}.k_1 = 1$, le coefficient $k_1$ étant ajustable par le choix des tensions de polarisation $U_A$ et $U_D$. Le déphaseur DE est conçu afin d'introduire un déphasage $\Phi_{DE}$ satisfaisant à la condition de phase $\Phi_1+\Phi_{DE}+\Phi_2=p.2.\pi$.

En référence à la Fig. 7, une second réalisation préférée d'un oscillateur à haute stabilité mettant en oeuvre un résonateur selon l'invention RE diffère de la première réalisation décrite ci-dessus en ce que l'électrode d'action 2 du résonateur RE n'est pas polarisée à une tension continue, la résistance $R_A$ étant supprimée, et en ce qu'un diviseur de fréquence par 2, DI, est introduit entre les amplificateurs A1 et A2, en cascade avec le déphaseur DE.

L'électrode d'action 2 n'étant pas polarisée, la réponse du résonateur RE est quadratique et l'amplificateur A1 délivre un signal sinusoïdal $v_R$ dont la fréquence est le double de la fréquence du signal d'action $v_a$. Le diviseur de fréquence DI divise par 2 la fréquence du signal $v_R$ et pallie ainsi à la multiplication de fréquence par 2 due à la réponse quadratique du résonateur RE.

Bien entendu diverses applications de l'invention peuvent être envisagées comme, par exemple, la réalisation de capteurs de force, de pression, d'accélération ou de température, utilisant le résonateur à plaque en tant qu'élément sensible.

## Revendications

1. Résonateur comprenant un support (6), une plaque résonnante (1) fixée audit support (6), une ou plusieurs premières électrodes ($2_1$ à $2_4$) et une ou plusieurs secondes électrodes ($3_1$ et $3_2$) respectivement pour exciter ladite plaque (1) selon un mode de vibration de contour et pour détecter des vibrations de la plaque (1), caractérisé en ce que la plaque (1) est en matériau solide élastique et a une longueur (n.L) multiple entier de la largeur (L) de la plaque, en ce que lesdites électrodes ($2_1$ à $2_4$, $3_1$ et $3_2$) n'adhèrent pas à la plaque (1) et sont disposées à la périphérie de la plaque (1) à une distance prédéterminée faible de la plaque (1), face à des chants de la plaque (1) et en regard de ventres de vibration, et en ce que la plaque (1) est fixée au support (6) en des points ($5_{11}$, $5_{12}$, $5_{21}$, $5_{22}$) correspondant à des noeuds de vibration de la plaque (1).

2. Résonateur conforme à la revendication 1, caractérisé en ce que ledit mode de vibration est un mode de Lamé selon lequel des ondes acoustiques de volume se propagent dans des directions à 45° des bords de la plaque (1).

3. Résonateur conforme à la revendication 1 ou 2, caractérisé en ce que le plaque (1) est en matériau conducteur ou semi-conducteur dopé en surface et est reliée à une masse de référence (M).

4. Résonateur conforme à la revendication 1 ou 2, caractérisé en ce que la plaque (1) est en matériau isolant et comprend en regard des électrodes ($2_1$, $2_2$, $3_1$, $3_2$) des chants métallisés (11) reliés à une masse de référence (M).

5. Résonateur conforme à l'une quelconque des revendications 1 ou 2, caractérisé en ce que la plaque (1) est en matériau isolant, et en ce que le support (6) comprend une surface conductrice (62) reliée à une masse de référence (M) et disposée par rapport aux électrodes (2, 3) et à la plaque (1) de sorte que la plaque (1) soit traversée par des lignes d'un champ électrique entre les électrodes (2, 3) et ladite surface conductrice (62).

6. Résonateur conforme à la revendication 4 ou 5, caractérisé en ce que la plaque (1) est en matériau cristallin du système cubique, et en ce que la plaque (1) est coupée de telle sorte que le plan de la plaque (1) soit perpendiculaire à un premier axe cristallographique (x) du matériau et que les bords de la plaque (1) soient parallèles ou à 45° des second et troisième axes cristallographiques (y et z) du matériau.

7. Résonateur conforme à la revendication 6, caractérisé en ce que la plaque (1) est en silicium ou germanium.

8. Résonateur conforme à la revendication 4 ou 5, caractérisé en ce que la plaque (1) est en matériau piézoélectrique et en ce que la plaque (1) est coupée de sorte que le plan de la plaque (1) corresponde à un plan d'isotropie du matériau.

9. Résonateur conforme à l'une quelconque des revendications 1 à 8, caractérisé en ce qu'il comprend des moyens (4) pour déphaser de $\pi$ un signal d'action ($v_a$) destiné à exciter la plaque (1) en un signal déphasé, ledit signal déphasé étant appliqué à des premières électrodes ($2_3$, $2_4$) en regard de premiers ventres de vibration déphasés de $\pi$ par rapport à des seconds ventres de vibration en regard desquels sont disposées d'autres premières électrodes ($2_1$, $2_2$) recevant directement le signal d'action ($v_a$).

10. Oscillateur comprenant un résonateur (RE), des moyens de déphasage (DE) et des moyens d'amplification (A2) connectés en boucle, caractérisé en ce que ledit résonateur (RE) est un résonateur conforme à l'une quelconque des revendications 1 à 9.

11. Oscillateur conforme à la revendication 10, caractérisé en ce qu'il comprend des moyens (A1) reliés en entrée aux secondes électrodes (3) pour produire un signal ($v_R$) représentatif d'une variation de capacité (dC) entre les secondes électrodes (3) et une masse de référence (M), ladite variation de capacité (dC) étant due aux vibrations de la plaque (1) du résonateur (RE).

12. Oscillateur conforme à la revendication 10 ou 11, caractérisé en ce qu'il comprend des moyens ($R_A$, $R_D$) pour polariser les premières et secondes électrodes (2 et 3) du résonateur (RE) respectivement à des première et seconde tensions continues ($V_A$ et $V_D$).

13. Oscillateur conforme à la revendication 11, caractérisé en ce qu'il comprend des moyens ($R_D$) pour polariser les secondes électrodes (3) du résonateur (RE) à une tension continue ($U_D$), et des moyens (DI), en cascade avec lesdits moyens pour produire le signal représentatif d'une variation de capacité (dC) entre les secondes électrodes (3) et la masse de référence (M) (A1), pour diviser en fréquence par deux ledit signal ($v_R$).

**Patentansprüche**

1. Resonator mit einem Träger (6), einer auf dem Träger (6) befestigten Resonanzplatte (1), einer oder mehreren ersten Elektroden ($2_1$ bis $2_4$) und einer oder mehrerer zweiter Elektroden ($3_1$ und $3_2$) zur Anregung der Platte (1) mit einem Umfangsschwingungsmodus und zur Entdeckung der Schwingungen der Platte (1), dadurch gekennzeichnet, daß die Platte (1) aus einem festen, elastischen Material besteht und eine Länge (n.L) aufweist, die einem ganzzahligen Vielfachen der Dicke (L) der Platte entspricht, und dadurch, daß die Elektroden ($2_1$ bis $2_4$, $3_1$ und $3_2$) die Platte (1) nicht berühren und auf der Außenseite der Platte (1) in einer vorgegebenen, angesichts der Schmalseiten der Platte (1) und im Hinblick auf die Platte (1) und im Hinblick auf die Schwingungsbäuche kleinen Entfernung von der Platte (1) angeordnet sind, und dadurch, daß die Platte (1) auf dem Träger (6) an Punkten ($5_{11}$, $5_{12}$, $5_{21}$, $5_{22}$), die den Schwingungsknoten der Platte (1) entsprechen, befestigt ist.

2. Resonator nach Anspruch 1, dadurch gekennzeichnet, daß der Schwingungsmodus ein Lamé-Modus ist, nach dem sich akustische Volumenwellen in 45°-Richtungen zu den Rändern der Platte (1) ausbreiten.

3. Resonator nach Anspruch 1 oder 2, dadurch gekennzeichnet, daß die Platte (1) aus leitfähigem oder oberflächendotiertem Halbleitermaterial besteht und mit einer Referenzmasse (M) verbunden ist.

4. Resonator nach Anspruch 1 oder 2, dadurch gekennzeichnet, daß die Platte (1) aus isolierendem Material besteht und bezüglich der Elektroden ($2_1$, $2_2$, $3_1$, $3_2$) metallisierte Schmalseiten (11), die mit einer Referenzmasse (M) verbunden sind, aufweist.

5. Resonator nach einem der Ansprüche 1 oder 2, dadurch gekennzeichnet, daß die Platte (1) aus isolierendem Material besteht und daß der Träger (6) eine leitfähige Oberfläche (62) aufweist, die mit einer Referenzmasse (M) verbunden ist und die bezüglich der Elektroden (2, 3) und der Platte (1) so angeordnet ist, daß die Platte (1) von elektrischen Feldlinien zwischen den Elektroden (2, 3) und der leitfähigen Oberfläche (62) durchdrungen wird.

6. Resonator nach Anspruch 4 oder 5, dadurch gekennzeichnet, daß die Platte (1) aus einem kubischkristallinen Material besteht, und daß die Platte (1) so geschnitten ist, daß die Ebene der Platte (1) senkrecht zu einer ersten kristallografischen Achse (x) des Materials und die Ränder der Platte (1) parallel oder unter 45° zu zweiten und dritten kristallografischen Achsen (y und z) des Materials verlaufen.

7. Resonator nach Anspruch 6, dadurch gekennzeichnet, daß die Platte (1) aus Silizium oder Germanium besteht.

8. Resonator nach Anspruch 4 oder 5, dadurch gekennzeichnet, daß die Platte (1) aus piezoelektrischem Material besteht und daß die Platte (1) so geschnitten ist, daß die Ebene der Platte (1) einer Isotropie-Ebene des Materials entspricht.

9. Resonator nach einem der Ansprüche 1 bis 8, dadurch gekennzeichnet, daß er Einrichtungen (4) zur Verschiebung der Phase eines Aktionssignals ($v_a$), das dazu bestimmt ist, die Platte (1) anzuregen, um $\pi$ in ein phasenverschobenes Signal aufweist, wobei das phasenverschobene Signal auf die ersten Elektroden ($2_3$, $2_4$) bezüglich ersten Schwingungsbäuchen gegeben wird, die um $\pi$ bezüglich zweiten Schwingungsbäuchen, bezüglich denen andere erste Elektroden ($2_1$, $2_2$) angeordnet sind, die das Aktionssignal ($v_a$) direkt empfangen,

phasenververschoben sind.

10. Oszillator mit einem Resonator (RE), Einrichtungen zur Phasenverschiebung (DE) und Verstärkungseinrichtungen (A2), die zu einer Schleife geschaltet sind, dadurch gekennzeichnet, daß der Resonator (RE) ein Resonator nach einem der Ansprüche 1 bis 9 ist.

11. Oszillator nach Anspruch 10, dadurch gekennzeichnet, daß er Einrichtungen (A1), die mit ihrem Eingang mit den zweiten Elektroden (3) verbunden sind, zur Erzeugung eines für eine Kapazitätsänderung (dC) zwischen den zweiten Elektroden (3) und einer Referenzmasse (M) representativen Signals ($V_R$), wobei die Kapazitätsänderung (dC) auf Schwingungen der Platte (1) des Resonators (RE) beruht.

12. Oszillator nach Anspruch 10 oder 11, dadurch gekennzeichnet, daß er Einrichtungen ($R_A$, $R_D$) zur Polarisierung der ersten und zweiten Elektroden (2 und 3) des Resonators (RE) in erste und zweite Gleichspannungen ($V_A$ und $V_D$) aufweist.

13. Oszillator nach Anspruch 11, dadurch gekennzeichnet, daß er Einrichtungen ($R_D$) zur Polarisierung der zweiten Elektroden (3) des Resonators (RE) in eine Gleichspannung ($U_D$), und in Kaskade mit den Einrichtungen zur Erzeugung des Signals, das representativ ist für eine Kapazitätsänderung (dC) zwischen den zweiten Elektroden (3) und der Referenzmasse (M) (A1), Einrichtungen (DI) zur Halbierung der Frequenz des Signals ($v_R$) aufweist.


## Claims

1. Resonator comprising a supporting base (6), a resonating plate (1) attached to said supporting base (6), one or plural first electrodes ($2_1$ to $2_4$) and one or plural second electrodes ($3_1$ and $3_2$) for respectively exciting said plate (1) according to a contour vibration mode and for detecting vibrations in the plate (1), characterized in that the plate (1) is made of elastic solid material and has a length (n.L) integral multiple of the width (L) of the plate, in that said electrodes ($2_1$ to $2_4$, $3_1$ and $3_2$) do not adhere to the plate (1) and are placed at the periphery of the plate (1) and at a short predetermined distance from the plate (1), opposite edges of the plate (1) and opposite vibration loops, and in that the plate (1) is attached to the supporting base (6) at points ($5_{11}$, $5_{12}$, $5_{21}$, $5_{22}$) corresponding to vibration nodes of the plate (1).

2. Resonator according to claim 1, characterized in that said vibration mode is a Lamé mode according to which volume acoustic waves are radiated in directions at 45° from edges of the plate (1).

3. Resonator according to claim 1 or 2, characterized in that the plate (1) is made of conductive or semi-conductive material with surface doping and is connected to a reference ground (M).

4. Resonator according to claim 1 or 2, characterized in that the plate (1) is made of insulating material and comprises metallized edges (11) connected to a reference ground (M), opposite the electrodes ($2_1$, $2_2$, $3_1$, $3_2$),

5. Resonator according to any one of claims 1 or 2, characterized in that the plate (1) is made of insulating material, and in that the supporting base (6) comprises a conductive surface (62) connected to a reference ground (M) and placed with regard to said electrodes (2, 3) and to the plate (1) in such a way that the plate (1) is traversed by the lines of an electric field between the electrodes (2,3) and said conductive surface (62).

6. Resonator according to claim 4 or 5, characterized in that the plate (1) is made of crystalline material of the cubic system, and in that the plate (1) is cut in such a way that the plane of the plate (1) is perpendicular to a first crystallographic axis (x) of the material and that the edges of the plate (1) are parallel or at 45° to second and third crystallographic axes (y and z) of the arterial.

7. Resonator according to claim 6, characterized in that said plate (1) is made of silicon or gemanium.

8. Resonator according to claim 4 or 5, characterized in that the plate (1) is made of piezoelectric material and in that the plate (1) is cut in such a way that the plane of the plate (1) corresponds to an isotropic plane of the material.

9. Resonator according to any one of claims 1 to 8, characterized in that it comprises means (4) for phase shifting by $\pi$ an action signal ($v_a$) intended to excite the plate (1) into a phase shifted signal, said phase shifted signal being applied at first electrodes ($2_3$, $2_4$) opposite first vibration loops phase shifted by $\pi$ with regard with to second vibration loops opposite which are placed other first electrodes ($2_1$, $2_2$) receiving the action signal ($v_a$) directly.

10. Oscillator comprising a resonator (RE), phase shifting means (DE) and amplifying means (A2) connected in a loop, characterized in that said resonator (RE) is a resonator according to any one of claims 1 to 9.

11. Oscillator according to claim 10, characterized in that it comprises means (A1) connected at input to the second electrodes (3) for producing a signal ($v_R$) representative of a capacitance variation (dC) between the second electrodes (3) and a reference ground (M), said capacitance variation (dC) being due to vibrations of the plate (1) of the resonator (RE).

12. Oscillator according to claim 10 or 11, characterized in that it comprises means ($R_A$, $R_D$) for biasing the first and second electrodes (2 and 3) of the resonator (RE) respectively at first and second d.C voltages ($V_A$ and $V_D$).

13. Oscillator according to claim 11, characterized in that it comprises means ($R_D$) for biasing the second electrodes (3) of the resonator (RE) at a d.c voltage (UD), and means (DI), in cascade with said means for producing the signal representative of a capacitance variation (dC) between the second electrodes (3) and the reference ground (M)(A1), for dividing by two the frequency of said signal ($v_R$).

# FIG.1

# FIG.3

# FIG.2

FIG.4

FIG.5

FIG.6

FIG.7